# EUROPEAN PATENT APPLICATION

(11) **EP 1 788 618 A1**
(43) Date of publication of application: **23.05.2007**
(21) Application number: 05767254.5
(22) Date of filing: 29.07.2005
(51) Int. Cl.: H01L 21/027, G03F 7/20

(54) **SUBSTRATE PROCESSING METHOD**

(30) Priority: 09.08.2004 JP 2004232085
(71) Applicant: Tokyo Electron Ltd., Tokyo 107-8481 (JP)
(72) Inventor: SHIMOAOKI, Takeshi, Tokyo Electron Kyushu Ltd., Kumamoto861-1116 (JP); KYOUDA, Hideharu, Tokyo Electron Kyushu Ltd., Kumamoto 8611116 (JP); NIWA, Takafumi, Tokyo Electron kyushu Ltd., Kumamoto 8611116 1116 (JP)
(74) Representative: Goddar, Heinz J.
(86) International application number: PCT/JP2005/013938
(87) International publication number: WO 2006/016489

(57) **Abstract**

A resist film is formed on a surface of a wafer. Then, a liquid layer used for irradiating the resist film with exposure light rays is formed from a liquid between an optical component facing the resist film and the surface of the wafer. The liquid is capable of transmitting the exposure light rays and has a function of cleaning a surface of the wafer and a surface of the optical component. Then, the resist film is irradiated with the exposure light rays projected from the optical component and transmitted through the liquid layer, to perform light exposure with a predetermined pattern on the resist film. Then, development is performed on the wafer after the light exposure, to form a predetermined pattern on the wafer.

## Description

### Technical Field

The present invention relates to a substrate processing method for performing light exposure and development on a resist film formed on a substrate, such as a semiconductor wafer, and further to a computer readable storage medium.

### Background Art

In a photolithography step used as one of the steps for manufacturing semiconductor devices, a circuit pattern is formed on a semiconductor wafer, as follows. Specifically, a resist liquid is applied onto the surface of the semiconductor wafer to form a resist film. Then, the resist film thus formed is subjected to light exposure with a predetermined pattern. Then, the light-exposed resist film is subjected to development to form the circuit pattern on the semiconductor wafer.

In recent years, the circuit patterns of semiconductor devices show a rapid change in terms of decrease in line width, miniaturization in shape, and increase in integration degree, which makes it necessary to improve the resolving power of light exposure. For this purpose, light exposure techniques using extreme ultraviolet lithography (EUVL) or dimeric fluorine (F₂) have been developed. Further, light exposure techniques using, e.g., argon fluoride (ArF) or krypton fluoride (KrF) have been under review for improvement. For example, Patent Document 1 discloses a technique of performing light exposure while providing the substrate surface with a light-transmitting liquid layer (which will be referred to as "liquid immersion light exposure" hereinafter). Specifically, the liquid immersion light exposure is a technique arranged to fill the gap between a lens and a semiconductor wafer with a liquid, such as purified water, through which light is transmitted. This technique utilizes a change in wavelength, such that for example, the wavelength of ArF is changed from 193 nm to 134 nm in purified water.

In the liquid immersion light exposure, if particles or the like are present on the surfaces of the resist film and lens, which are in contact with the liquid, the resolving power is greatly deteriorated. Further, particles on the surface of the resist film may generate development defects. Furthermore, after the light exposure, if post exposure baking or development is performed on the resist film with particles present thereon, the particles may generate development defects.
[Patent Document 1]
International Publication No. WO 99/49504

### Disclosure of Invention

An object of the present invention is to provide a substrate processing method that allows liquid immersion light exposure to be high in resolving power and low in development defect generation.
An alternative object of the present invention is to provide a computer readable storage medium that stores a control program for executing the substrate processing method described above.

According to the present invention, there is provided a substrate processing method comprising: forming a resist film on a surface of a substrate; forming a liquid layer between an optical component facing the resist film and the surface of the substrate, the liquid layer being set for irradiating the resist film with exposure light rays and capable of transmitting the exposure light rays; irradiating the resist film with the exposure light rays projected from the optical component and transmitted through the liquid layer, thereby performing light exposure on the resist film; and performing development on the substrate after the light exposure, wherein the liquid layer comprises a liquid having a function of cleaning a surface of the substrate and a surface of the optical component.

In the substrate processing method according to the present invention, the liquid for forming the liquid layer is preferably prepared by dissolving a surfactant in purified water. It is preferable that, after the resist film is formed and before the liquid layer is formed, the method further comprises cleaning the surface of the substrate by a cleaning liquid. It is also preferable that, after the light exposure and before the development, the method further comprises cleaning the surface of the substrate, treated by the light exposure, by a cleaning liquid, and then performing a heat process on the substrate. In other way around, it may be arranged such that, after the light exposure and before the development, the method further comprises performing a heat process on the substrate, treated by the light exposure, and then cleaning the surface of the substrate by a cleaning liquid. Where such a cleaning step is performed, it is possible to decrease the number of particles and to prevent development defects from being generated, thereby forming a circuit pattern having a good shape. The cleaning liquid used for this process is preferably prepared by dissolving a surfactant in purified water.

According to another aspect of the present invention, there is provided a computer readable storage medium that stores a software for a computer to execute a control program, wherein the control program, when executed, causes the computer to control a substrate processing apparatus to perform a substrate processing method comprising: forming a resist film on a surface of a substrate; forming a liquid layer between an optical component facing the resist film and the surface of the substrate, the liquid layer being set for irradiating the resist film with exposure light rays and capable of transmitting the exposure light rays; irradiating the resist film with the exposure light rays projected from the optical component and transmitted through the liquid layer, thereby performing light exposure on the resist film; and performing development on the substrate after the light exposure, wherein the liquid layer comprises a liquid having a function of cleaning a surface of the substrate and a surface of the optical component.

The present invention allows liquid immersion light exposure to be high in resolving power and low in development defect generation. Further, where a cleaning step for the substrate is performed before or after the liquid immersion light exposure, it is possible to form a good circuit pattern with a smaller number of development defects.

### Brief Description of Drawings

[FIG. 1] This is a plan view schematically showing the structure of a processing system.
[FIG. 2] This is a front view schematically showing the structure of the processing system.
[FIG. 3] This is a back view schematically showing the structure of the processing system.
[FIG. 4] This is a sectional view schematically showing the structure of a light exposure section used in a liquid immersion light exposure apparatus.
[FIG. 5] This is a flowchart showing a first wafer process.
[FIG. 6] This is a flowchart showing a second wafer process.
[FIG. 7] This is a flowchart showing a third wafer process.
[FIG. 8] This is a flowchart showing a fourth wafer process.

### Best Mode for Carrying Out the Invention

Embodiments of the present invention will now be described with reference to the accompanying drawings.

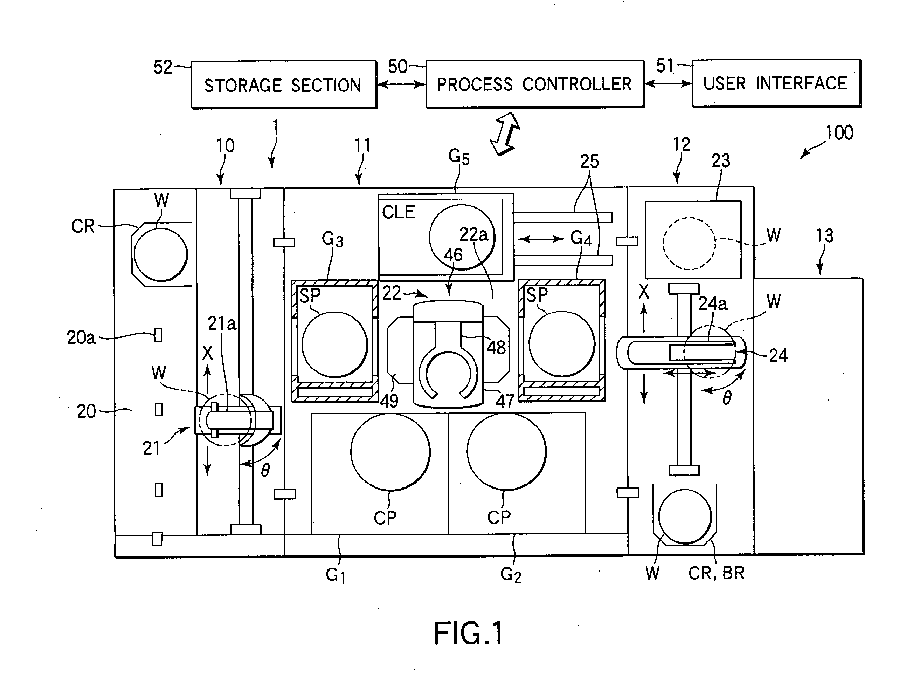

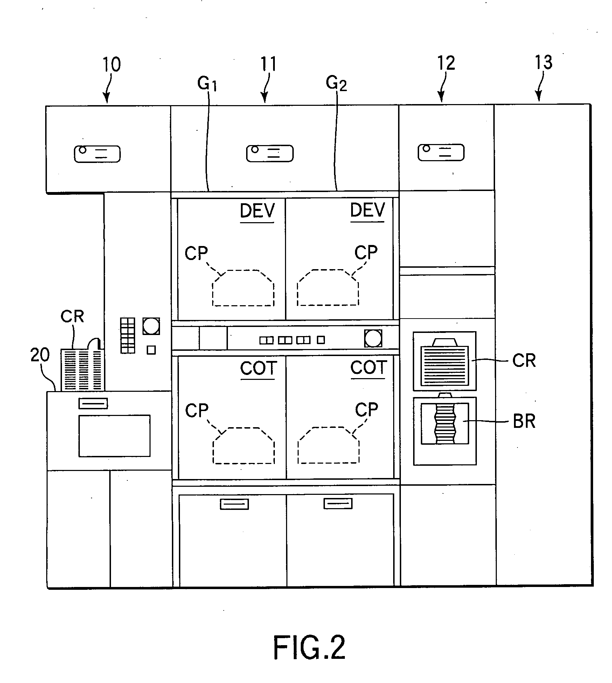

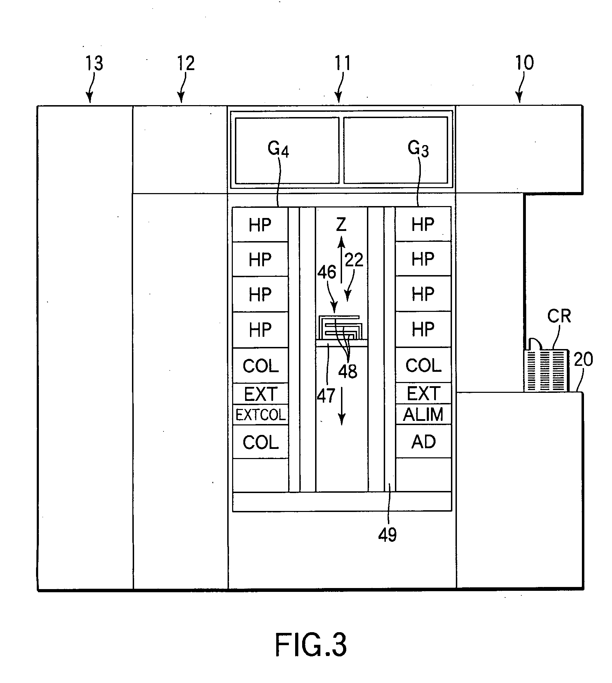

FIG. 1 is a plan view schematically showing a processing system that can serially perform resist coating, light exposure, and developing processes. FIG. 2 is a front view of the processing system. FIG. 3 is a back view of the processing system. This processing system 100 includes a resist coating/developing system 1 used for resist coating and developing processes, and a liquid immersion light exposure apparatus 13.

The resist coating/developing system 1 comprises a cassette station 10 used as a transfer station; a process station 11 including a plurality of processing units; and an interface section 12 disposed adjacent to the process station 11 and configured to transfer wafers W to and from a liquid immersion light exposure apparatus 13.

The cassette station 10 is used such that wafer cassettes CR are transferred therethrough from other systems to the resist coating/developing system 1. Each of the wafer cassettes CR stores, essentially in a horizontal state, a plurality of (e.g., 25) target objects or wafers W at predetermined intervals in the vertical direction (Z direction). The cassette station 10 is also used such that wafer cassettes CR are transferred therethrough from the resist coating/developing system 1 to the outside. Further, the cassette station 10 is used to transfer wafers W between the wafer cassettes CR and process station 11.

The cassette station 10 includes a cassette table 20 for placing wafer cassettes CR thereon. As shown in FIG. 1, the cassette station 10 is provided with a plurality of (four in this embodiment) positioning projections 20a arrayed thereon in an X direction in FIG. 1. The wafer cassettes CR are placed in a row at positions set by the projections 20a while their wafer port openings are directed toward the process station 11.

The cassette station 10 includes a wafer transfer mechanism 21 located between the cassette table 20 and process station 11. The wafer transfer mechanism 21 includes a wafer transfer arm 21a, which is movable in the cassette array direction (X-direction) and the array direction of wafers W stored therein (Z-direction). Accordingly, the wafer transfer arm 21a can selectively access any one of the wafer cassettes CR. Further, the wafer transfer arm 21a is rotatable in a θ-direction, as shown in FIG. 1, so that it can also access an alignment unit (ALIM) and an extension unit (EXT) that belongs to a third processing section G3 in the process station 11, as described later.

The process station 11 includes a plurality of processing units for performing a series of steps for subjecting wafers W to coating and developing processes. The processing units are stacked one on the other and each of the processing units is configured to process wafers W one by one. As shown in FIG. 1, the process station 11 has a wafer transfer passage 22a at the center, in which a main wafer transfer mechanism 22 is located, while all the processing units are set up around the wafer transfer passage 22a. The processing units are divided to belong to a plurality of processing sections, each of which includes a plurality of processing units stacked in the vertical direction (Z-direction).

As shown in FIG. 3, the main wafer transfer mechanism 22 includes a wafer transfer unit 46 disposed inside a cylindrical support 49 and configured to be moved up and down in the vertical direction (Z-direction). The cylindrical support 49 is rotatable integrally with the wafer transfer unit 46 by a rotational driving force given from a motor (not shown). The wafer transfer unit 46 includes a transfer base 47 and a plurality of holding members 48 movable back and forth on the transfer base 47. The holding members 48 are used to transfer wafers W between the processing units.

As shown in FIG. 1, in the process station 11, five processing sections G1, G2, G3, G4, and G5 are located around the wafer transfer passage 22a. Of them, the first and second processing sections G1 and G2 are located side by side on the front side of the resist coating/developing system 1 (the near side in FIG. 1). The third processing section G3 is located adjacent to the cassette station 10, while the fourth processing section G4 is-located adjacent to the interface section 12. The fifth processing section G5 is located on the rear side.

The first processing section G1 includes two processing units of the spinner type stacked one on the other, in each of which a predetermined process is performed on a wafer W placed on a spin chuck (not shown) inside a coater cup (CP). These two processing units are formed of a resist coating unit (COT) and a developing unit (DEV) in this order from below. The second processing section G2 has the same structure as that of the first processing section G1.

As shown in FIG. 3, the third processing section G3 includes eight processing units of the oven type stacked one on the other, in each of which a predetermined process is performed on a wafer W placed on a worktable SP. These eight processing units are formed of, in this order from below, an adhesion unit (AD) for performing a so-called hydrophobization process to improve resist fixation; an alignment unit (ALIM) for performing alignment; an extension unit (EXT) for transferring wafers W; a cooling unit (COL) for performing a cooling process; and four hot plate units (HP) for performing a heat process on wafers W before and after the light exposure process and after the developing process. In place of the alignment unit (ALIM), a cooling unit (COL) with an alignment function may be disposed.

The fourth processing section G4 also includes eight processing units of the oven type stacked one on the other. These eight processing units are formed of, in this order from below, a cooling unit (COL); an extension and cooling unit (EXTCOL) having a cooling plate and configured as a wafer transfer portion; an extension unit (EXT); a cooling unit (COL); and four hot plate units (HP).

The fifth processing section G5 includes a cleaning unit (CLE) configured to supply a cleaning liquid onto the surface of a wafer W to clean the surface of the wafer W while rotating the wafer W. Although the structure of the cleaning unit (CLE) is not shown, it includes a spin chuck for holding and rotating the wafer W, a cup for surrounding wafer W held on the spin chuck, and a cleaning liquid supply nozzle for supplying the cleaning liquid onto the surface of the wafer W. The cleaning liquid is preferably formed of a liquid that has the cleaning function of removing contaminants, such as particles, deposited on the surface of the wafer W, but does not dissolve the resist film. For example, a liquid prepared by dissolving a surfactant in purified water is preferably used as the cleaning liquid.

The fifth processing section G5 is arranged to be movable laterally relative to the main wafer transfer mechanism 22 along a guide rail 25. Accordingly, a space is formed by sliding the fifth processing section G5 along the guide rail 25, so that a maintenance operation can be easily performed on the main wafer transfer mechanism 22 from behind.

As shown in FIGS. 1 and 2, the interface section 12 includes a buffer cassette BR of the stationary type and a pickup cassette CR of the portable type stacked one on the other at two levels on the front side. The interface section 12 further includes a periphery light exposure unit 23 located on the rear side, and a wafer transfer mechanism 24 located at the center. The wafer transfer mechanism 24 includes a wafer transfer arm 24a, which is movable in the X-direction and Z-direction, so that it can access the two cassettes CR and BR and periphery light exposure unit 23. Further, the wafer transfer arm 24a is rotatable in a horizontal plane (*θ-*direction), so that it can also access the extension unit (EXT) located in the fourth processing section G4 of the process station 11 and a wafer transfer table (not shown) of the liquid immersion light exposure apparatus 13 adjacent thereto.

Next, an explanation will be given of the liquid immersion light exposure apparatus 13 for performing liquid immersion light exposure.

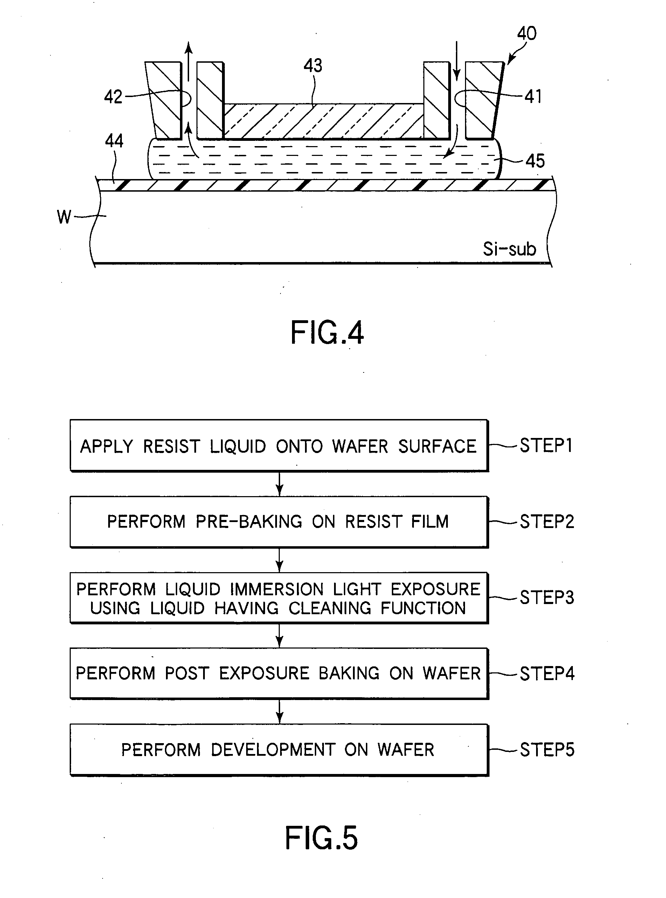

FIG. 4 is a sectional view schematically showing the structure of a light exposure section used in the liquid immersion light exposure apparatus 13. The light exposure section 40 includes a lens 43 located to face the surface of a wafer W with a certain gap interposed therebetween, while the wafer W is held in a horizontal state by a holding mechanism (not shown). Outside the lens 43, there is a liquid supply port 41 for delivering a liquid that has the property of transmitting exposure light rays, and a liquid collection port 42 for sucking and collecting the delivered liquid.

The wafer W has a resist film 44 formed on the surface. The liquid is delivered from the liquid supply port 41 and collected into the liquid collection port 42, such that a liquid layer 45 is thereby formed between the surface of the wafer W (specifically the surface of the resist film 44) and the bottom surface of the lens 43. While the liquid layer 45 is present between the surface of the wafer W and the bottom surface of the lens 43, exposure light rays emitted from a light source (not shown) are guided through a predetermined optical path to the lens 43, and narrowed down by the lens 43. Then, the exposure light rays are transmitted through the liquid layer 45, and radiated onto the surface of the wafer W. Consequently, a circuit pattern is duplicated on the resist film 44 formed on the surface of the wafer W. After the pattern duplication is finished on a predetermined duplicate region (shot region), the wafer W and light exposure section 40 are horizontally moved relative to each other, and then the pattern duplication is performed on another duplicate region in the same way.

In general, if contaminants, such as particles, are present on the resist film 44 during a light exposure process, portions directly blow the contaminants cannot receive exposure light rays, thereby generating defects in a circuit pattern obtained by the subsequent developing process. Further, if contaminants, such as particles, are deposited on the bottom surface of the lens 43, the intensity of exposure light rays becomes uneven, thereby making it difficult to obtain a good circuit pattern. Furthermore, if particles or the like present on the resist film are separated therefrom and then re-deposited on the resist film 44 and/or lens 43, the problems described above are also caused.

The liquid immersion light exposure is a technique for forming circuit patterns with a small line width and a high integration degree. Consequently, it is essential to set process conditions to prevent defects of this kind from being generated. For this purpose, used as the liquid supplied into the gap between the surface of the wafer W and the bottom surface of the lens 43 is a liquid that has the function of cleaning the surfaces of the resist film 44 and lens 43, e.g., the function of removing contaminants, such as particles, deposited on the surfaces of the resist film 44 and lens 43. Where a liquid having this cleaning function is used, it is also possible that contaminants, such as particles, separated from the resist film 44 and so forth are prevented from being re-deposited on the resist film and so forth. Further, even if the liquid supplied into the gap between the surface of the wafer W and the bottom surface of the lens 43 contains contaminants, such as particles, mixed therein, the contaminants are prevented from being deposited on the resist film 44 and so forth. Consequently, the resolving power of light exposure is improved.

Specifically, a liquid prepared by dissolving a surfactant in purified water is preferably used as the liquid for the liquid immersion light exposure. It is preferable that the surfactant is low,in foaming property. If gas bubbles are generated in the liquid, they scatter exposure light rays and thereby deteriorate the resolving power. Further, where gas bubbles are present on the surface of the wafer W and/or the bottom surface of the lens, they deteriorate the resolving power. Incidentally, the surfactant dissolved in purified water may greatly change the refractive index and/or lower the light-transmittancy, thereby deteriorating the resolving power. In light of this, the concentration of the surfactant is set to be within a range with which the resolving power is not deteriorated. The surfactant is preferably an ampho-ionic surfactant or non-ionic surfactant. The ampho-ionic surfactant is exemplified by an amine oxide family ampho-ionic surfactant. The non-ionic surfactant is exemplified by an acetylene alcohol family surfactant or alkylene glycol family surfactant.

Next, an explanation will be given of the control system of the processing system 100.
As shown in FIG. 1, each of the respective components in the processing system 100 is connected to and controlled by the process controller 50 having a CPU. The process controller 50 is connected to a user interface 51, which includes, e.g., a keyboard and a display, wherein the keyboard is used for a process operator to input commands for administrating the processing system 100, and the display is used for showing visualized images of the operational status of the processing system 100.

Further, the process controller 50 is connected to the storage section 52, which stores control programs for the processing system 100 to perform various processes under the control of the process controller 50, and programs or recipes for respective components of the processing system 100 to perform processes in accordance with process conditions. Recipes may be stored in a hard disk or semiconductor memory, or stored in a portable storage medium, such as a CDROM or DVD, to be attached to a predetermined position in the storage section 52. Further, a recipe may be transmitted from another apparatus through, e.g., a dedicated line, as needed.

A required recipe is retrieved from the storage section 52 and executed by the process controller 50 in accordance with an instruction or the like input through the user interface 51. Consequently, a predetermined process is performed in the processing system 100 under the control of the process controller 50.

Next, an explanation will be given of a process performed on a wafer W in the processing system described above.
FIG. 5 is a flowchart schematically showing a first wafer process.
In the first wafer process, at first, a wafer W is transferred into a resist coating unit (COT), in which a resist liquid is applied to form a resist film (STEP 1). Before the wafer W is transferred into the resist coating unit (COT), in the cassette station 10 of the resist coating/developing system 1, the wafer transfer arm 21a of the wafer transfer mechanism 21 accesses a wafer cassette CR that stores unprocessed wafers W on the cassette table 20. A wafer W is taken out from the wafer cassette CR by the wafer transfer arm 21a and is transferred into the extension unit (EXT) of the third processing section G3. Then, the wafer W is transferred by the wafer transfer unit 46 of the main wafer transfer mechanism 22 from the extension unit (EXT) into the alignment unit (ALIM) located in the third processing section G3, in which alignment of the wafer W is performed. Subsequently, the wafer W is transferred into the adhesion processing unit (AD), in which a hydrophobization process (HMDS process) is performed on the wafer W to improve the resist fixation. Since this HMDS process involves heating, the wafer W treated by the HMDS process is then transferred by the wafer transfer unit 46 into a cooling unit (COL), in which the wafer W is cooled. Depending on the type of resist used at this time, the wafer W may be directly transferred into a resist coating unit (COT) without performing the HMDS process. For example, this is a case where a polyimide family resist is used.

Through the course described above, the wafer W is transferred by the wafer transfer unit 46 into a resist coating unit (COT), in which a resist film is formed, as described above. After the coating process is finished, the wafer W is subjected to a pre-baking process in one of the hot plate units (HP) located in the third and fourth processing sections G3 and G4 (STEP 2). Thereafter, the wafer W is subjected to cooling in one of the cooling units (COL).

The wafer W thus cooled is transferred into the alignment unit (ALIM) located in the third processing section G3, in which alignment of the wafer W is performed. Thereafter, the wafer W is transferred through the extension unit (EXT) of the fourth processing section G4 into the interface section 12.

Then, the wafer W is subjected to periphery light exposure in the periphery light exposure unit 23 to remove an unnecessary portion of the resist film. Thereafter, the wafer W is transferred into the liquid immersion light exposure apparatus 13 adjacent to the interface section 12. In the liquid immersion light exposure apparatus 13, as described above, a light exposure process is performed on the resist film while a layer of a liquid having a cleaning function is formed between the lens 43 and the surface of the wafer W (STEP 3).

After the light exposure process is finished, the wafer W is returned by the wafer transfer mechanism 24 into the interface section 12 of the resist coating/developing system 1, and is transferred into the extension unit (EXT) of the fourth processing section G4. Then, the wafer W is transferred by the wafer transfer unit 46 into one of the hot plate units (HP), in which the wafer W is subjected to a post exposure baking process (STEP 4). Then, the wafer W is transferred into one of the cooling units (COL), in which the wafer W is cooled.

Thereafter, the wafer W is transferred into a development unit (DEV), in which development is performed on the light-exposed pattern (STEP 5). After the development is finished, the wafer W is transferred into one of the hot plate units (HP), in which the wafer W is subjected to a post-baking process. Then, the wafer W is transferred into a cooling unit (COL), in which the wafer W is cooled. After the series of processes are finished, the wafer W is returned through the extension unit (EXT) of the third processing section G3 into the cassette station 10 and is inserted into one of the wafer cassettes CR.

The first wafer process does not use the cleaning unit (CLE) located in the fifth processing section G5. Next, an explanation will be give of second to fourth wafer processes including a cleaning process performed by the cleaning unit (CLE).

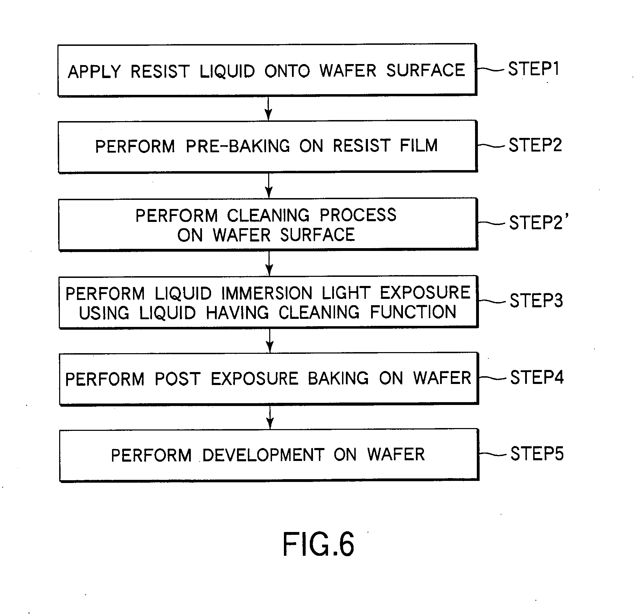

FIG. 6 is a flowchart schematically showing a second wafer process. As compared to the first wafer process described above, the second wafer process additionally includes a cleaning step for the surface of the wafer W after the resist film formation step and before the liquid immersion light exposure step. Specifically, the second wafer processing method is arranged to apply a resist liquid onto the surface of the wafer W to form a resist film (STEP 1); then perform a pre-baking process on the resist film (STEP 2); then transfer the wafer W into the cleaning unit (CLE) and perform a process for removing particles or the like from the resist film (STEP 2'); and then perform liquid immersion light exposure on the wafer W (STEP 3). Since particles or the like are removed from the resist film before the liquid immersion light exposure process, the resolving power of the liquid immersion light exposure is improved.

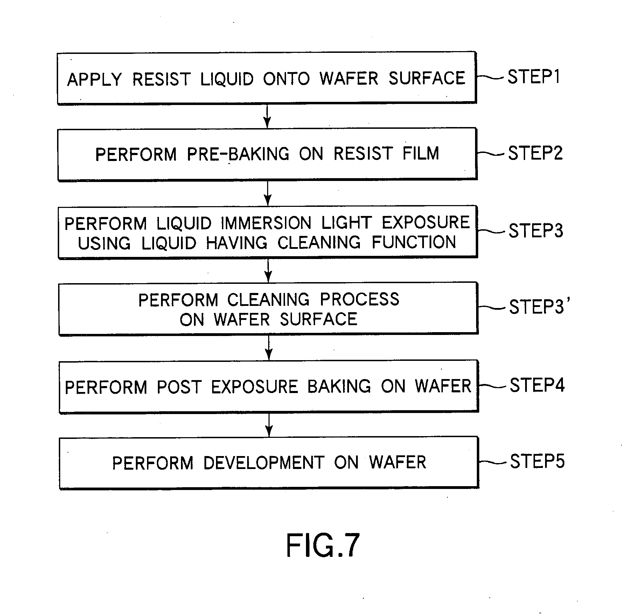

FIG. 7 is a flowchart schematically showing a third wafer process. As compared to the first wafer process described above, the third wafer process additionally includes a cleaning step (STEP 3') using the cleaning unit (CLE) for the wafer W after the liquid immersion light exposure step (STEP 3) and before the post exposure baking step (STEP 4). If a heat process is performed on the resist film with contaminants, such as particles, present thereon, the contaminants may become difficult to remove from the resist film. Where a cleaning process is performed before a heat process (post exposure baking process), it is possible to form a circuit pattern while suppressing defect generation thereon.

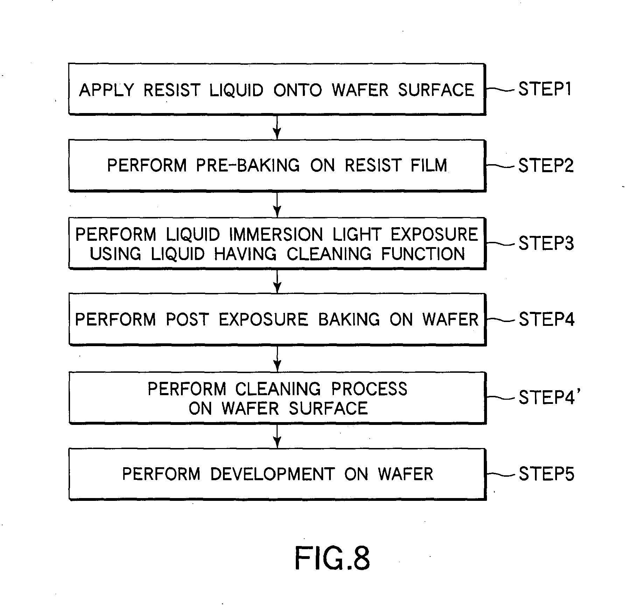

FIG. 8 is a flowchart schematically showing a fourth wafer process. As compared to the first wafer process described above, the fourth wafer process additionally includes a cleaning step (STEP 4') for the wafer W after the post exposure baking step (STEP 4) and before the development step (STEP 5). Where the wafer W is subjected to a cleaning process before the developing process, it is possible to suppress defect generation, such as deposition of particles on the resist pattern during the developing process.

A combination of the second to fourth wafer processes is further preferably used. Specifically, where two or three cleaning steps selected from STEP 2', STEP 3', and STEP 4' are performed after the resist film formation and before the developing process, it is possible to further suppress defect generation, thereby forming a circuit pattern with higher accuracy.

The embodiments described above are intended only to clarify the technical content of the present invention, and, therefore, the present invention should not be construed as being limited to the embodiments. Various modifications may be made without departing from the spirit of the present invention or the scope of the appended claims.

For example, where a cleaning step for the wafer W is included after the post exposure baking process step and before the developing process step, the cleaning unit (CLE) of the fifth processing section G5 may be omitted. In this case, the development units (DEV) may be additionally provided with the function of supplying a cleaning liquid onto the wafer W, so that the cleaning process and developing process can be serially performed. This arrangement makes it possible to shorten the transfer time of the wafer W, thereby improving the throughput.

The resist coating units (COT) may be additionally provided with the function of supplying a cleaning liquid onto the wafer W. The third processing section G3 or fourth processing section G4 may include a cleaning unit for the wafer W.

The cleaning unit is not limited to a structure that supplies a cleaning liquid while rotating the wafer W. For example, the cleaning unit may have a structure including a tank that stores purified water containing a surfactant dissolved therein, in which the wafer W is immersed and subjected to ultrasonic cleaning. Alternatively, the cleaning unit may have a structure including a plate member that faces the surface of the wafer W with a certain gap interposed therebetween, such that the gap is kept filled with a cleaning liquid while supplying the cleaning liquid into the gap and sucking the cleaning liquid therefrom.

### Industrial Applicability

The present invention is preferably applied to photolithography performed by liquid immersion light exposure, which is one of the steps for manufacturing semiconductor devices.

## Claims

1. A substrate processing method comprising:
forming a resist film on a surface of a substrate;
forming a liquid layer between an optical component facing the resist film and the surface of the substrate, the liquid layer being set for irradiating the resist film with exposure light rays and capable of transmitting the exposure light rays;
irradiating the resist film with the exposure light rays projected from the optical component and transmitted through the liquid layer, thereby performing light exposure on the resist film; and
performing development on the substrate after the light exposure,
wherein the liquid layer comprises a liquid having a function of cleaning a surface of the substrate and a surface of the optical component.

2. The substrate processing method according to claim 1, wherein the liquid is prepared by dissolving a surfactant in purified water.

3. The substrate processing method according to claim 1, wherein, after the resist film is formed and before the liquid layer is formed, the method further comprises cleaning the surface of the substrate by a predetermined cleaning liquid.

4. The substrate processing method according to claim 3, wherein the cleaning liquid is prepared by dissolving a surfactant in purified water.

5. The substrate processing method according to claim 1, wherein, after the light exposure and before the development, the method further comprises cleaning the surface of the substrate, treated by the light exposure, by a predetermined cleaning liquid, and then performing a heat process on the substrate.

6. The substrate processing method according to claim 5, wherein the cleaning liquid is prepared by dissolving a surfactant in purified water.

7. The substrate processing method according to claim 1, wherein, after the light exposure and before the development, the method further comprises performing a heat process on the substrate, treated by the light exposure, and then cleaning the surface of the substrate by a predetermined cleaning liquid.

8. The substrate processing method according to claim 7, wherein the cleaning liquid is prepared by dissolving a surfactant in purified water.

9. A computer readable storage medium that stores a software for a computer to execute a control program, wherein the control program, when executed, causes the computer to control a substrate processing apparatus to perform a substrate processing method comprising: forming a resist film on a surface of a substrate; forming a liquid layer between an optical component facing the resist film and the surface of the substrate, the liquid layer being set for irradiating the resist film with exposure light rays and capable of transmitting the exposure light rays; irradiating the resist film with the exposure light rays projected from the optical component and transmitted through the liquid layer, thereby performing light exposure on the resist film; and performing development on the substrate after the light exposure, wherein the liquid layer comprises a liquid having a function of cleaning a surface of the substrate and a surface of the optical component.
